(19) Europäisches Patentamt

European Patent Office

Office européen des brevets

(11) Veröffentlichungsnummer: **0 263 470 B1**

(12) **EUROPÄISCHE PATENTSCHRIFT**

(45) Veröffentlichungstag der Patentschrift: **17.02.93**

(21) Anmeldenummer: **87114519.9**

(22) Anmeldetag: **05.10.87**

(51) Int. Cl.⁵: **G11C 29/00**

(54) Verfahren und Anordnungen zum Testen von MEGA-Bit-Speicherbausteinen mit beliebigen Testmustern im Multi-Bit-Testmodus.

(30) Priorität: **08.10.86 DE 3634352**

(43) Veröffentlichungstag der Anmeldung:
**13.04.88 Patentblatt 88/15**

(45) Bekanntmachung des Hinweises auf die
Patenterteilung:
**17.02.93 Patentblatt 93/07**

(84) Benannte Vertragsstaaten:
**AT DE FR GB IT NL**

(56) Entgegenhaltungen:
**EP-A- 0 186 051
EP-A- 0 186 459
GB-A- 2 172 128
US-A- 4 541 090**

**IEEE 1986 INTERNATIONAL TEST CONFEREN-
CE PROCEEDINGS, 8.-11. September 1986,
paper 22.4, Seiten 826-829, IEEE, New York,
US; Y. NISHIMURA et al.: "Redundancy test
for 1 Mbit DRAM using multi-bit-test mode"**

**IEEE 1984 INTERNATIONAL TEST CONFEREN-
CE PROCEEDINGS, 16.-18. Oktober 1984, paper 4.3, Seiten 148-156, IEEE, New York, US;
Z. SUN et al.: "Self-testing of embedded

RAMs"**

(73) Patentinhaber: **SIEMENS AKTIENGESELL-
SCHAFT
Wittelsbacherplatz 2
W-8000 München 2(DE)**

(72) Erfinder: **Lieske, Normen, Dr.
Pfarrweg 22
W-8019 Steinhöring(DE)**
Erfinder: **Seichter, Werner, Dipl.-Ing.
Ampfingstrasse 46/IV
W-8000 München 80(DE)**

**Beschreibung**

Die Erfindung betrifft ein Verfahren zum Testen von Speicherbausteinen der Mega-Bit-Generation mit beliebigen Testmustern im Multi-Bit-Testmodus gemäß Anspruch 1, und zwei Anordnungen zur Durchführung des Verfahrens gemäß Anspruch 4 und Anspruch 5.

Die Speicherbausteine der Mega-Bit-Generation weisen, um die Testzeiten kurz zu halten, einen Multi-Bit-Testmodus auf, in dem gleichzeitig auf mehrere Zellen des Zellenfeldes eine am Dateneingang des Speicherbausteins eingelesene Testinformation abgebildet wird. Es werden zum Beispiel 1M (Worte) x 1 (Bit) organisierte Speicherbausteine so getestet, als seien sie zu 256 K x 4, 128 K x 8, 64 K x 16 usw. organisiert. Pro angelegte Speicheradresse werden dann gleichzeitig 4, 8, 16 Zellen usw., allgemein m Zellen, mit einem 1-Bit-Datum getestet, siehe zum Beispiel Dokument EP-A-0 186 051, US-A-4 541 090 oder 1986, IEEE International Test Conference proceedings, 8-11. Sept. 1986, paper 22.4, Seiten 826-829, US, New-York, die diesen genannten Stand der Technik illustrieren.

Die tatsächlich in die jeweils m Zellen eingeschriebenen Daten hängen von dem Baustein-Design der einzelnen Hersteller ab. Die eingeschriebenen Zellendaten sind das m-dimensionale Ergebnis der durch m-dimensionale Funktion

$$f\,(DE)\ =\ \{DE\}_{1,\ldots,m}\ \text{mit}\ DE_{\epsilon}\{0,\ 1\}$$

beschriebenen Zuordnung des Ein-Bit-Testdatums zu den einzelnen Zellen einer Zellengruppe. Dabei steht DE für eine Dateninformation, die in den Mega-Bit-Speicherbaustein eingelesen wird.

Beim Auslesen der Zelleninhalte einer Zellengruppe erfolgt die umgekehrte Zuordnung

$$f^{-1}(\{DA\}_{1,\ldots,m})\ =\ DA\ \text{mit}\ DA_{\epsilon}\{0,\ 1\}\ ,$$

so daß bei fehlerfreien Speicherzellen am Datenausgang des Speicherbausteines wieder das ursprüngliche Testdatum erscheint. DA steht für eine Dateninformation, die aus dem Mega-Bit-Speicherbaustein ausgelesen wird.

Beim Einschreiben des negierten Testdatums werden die Zellendaten negiert in die Zellen einer Zellengruppe geschrieben, so daß insgesamt gegenüber dem vorher eingeschriebenen Bitmuster das negierte Bitmuster in der Zellengruppe steht. Es gilt:

$$f\,(DE) = \begin{cases} f_1\,(DE)\ =\ \{D1\}_{1,\ldots,m} & \text{für } DE = 1 \\[2ex] f_0\,(DE)\ =\ \{D0\}_{1,\ldots,m} & \text{für } DE = 0 \end{cases} ,$$

wobei $f_0$ und $f_1 = \overline{f_0}$ durch das Bausteindesign vorgegebene Funktionen darstellen.

Jeder Speicherbaustein weist damit intern vom Baustein-Design abhängig und damit herstellerabhängig, ausgehend von dem Testdatum, genau eine Abbildungsfunktion f (DE) auf, die innerhalb einer Zellengruppe ein bestimmtes Bitmuster erzeugt. Das Bitmuster kann zum Testen des Speicherbausteins lediglich negiert werden. Mit den jeweils zwei zur Verfügung stehenden Bitmustern wird der Speicherbaustein aber nicht ausreichend auf Bitmusterempfindlichkeit getestet. Viele Fehler treten bei defekten Zellen erst dann auf, wenn deren Umfeld ein spezielles Bitmuster aufweist. Zur Erkennung solcher Fehler, die auf der Wechselbeziehung von wenigstens zwei Zellen beruhen, existiert eine Vielzahl topologischer Tests, die mit verschiedenen Testmustern arbeiten. Topologische Tests können aber in dem bisherigen Multi-Bit-Testmodus nicht uneingeschränkt durchgeführt werden, weil die dafür notwendigen Testmuster nicht in den Zellenfeldern erzeugt werden können. Sie können in Mega-Bit-Bausteinen nur im Einzelbitmodus durchgeführt werden. Dies ist aber unzweckmäßig, weil die Testzykluszeiten, die von der Testart und von der Speicherkapazität des Speicherbausteins abhängen, überproportional hoch sind. Es können Testzykluszeiten von bis zu mehreren hundert Stunden auftreten.

Aufgabe der Erfindung ist es daher, ein Verfahren und zwei Anordnungen zur Durchführung des Verfahrens anzugeben, mit denen bei Speicherbausteinen der Mega-Bit-Generation im Multi-Bit-Testmodus innerhalb einer Zellengruppe ein beliebiges Bitmuster erzeugt und damit topologische Tests mit verkürzten Testzeiten ermöglicht werden können.

Diese Aufgabe wird erfindungsgemäß für das Verfahren durch die kennzeichnenden Merkmale des Hauptanspruchs gelöst. Wesentlich dabei ist, daß nicht mehr eine feste, vom Design abhängige m-dimensionale Abbildung eines 1-Bit-Datums auf die Zellen einer Zellengruppe des Zellenfeldes erfolgt, sondern, daß zunächst ein mit beliebigen Einzeldaten versehenes Testwort mit zu den einzelnen Zellen einer Zellengruppe fest zugeordneten Einzelbits gebildet wird, das nachfolgend auf die Zellen einer Zellengruppe des Zellenfeldes abgebildet wird.

Zur Durchführung des Verfahrens weist die Anordnung der Speicherbausteine am Eingang des Zellenfeldes wenigstens ein zusätzliches Testwortregister mit einer der Anzahl einer zu testenden Zellengruppe entsprechenden Bitbreite auf. Am Ausgang des Zellenfeldes befindet sich eine Vergleichslogik, in der die aus dem Zellenfeld ausgelesenen Dateninformationen mit den Dateninformationen des usprünglich eingelesenen Testwortes verglichen werden.

Eine vorteilhafte Weiterbildung der Erfindung nützt zur Steuerung des Einlese- bzw. Schreibvorganges eines Testwortes in das Testwortregister bzw. eines Testwortes in das Zellenfeld eine wegen des Multi-Bit-Testmodus verringerten zu adressierenden Adreßraumes freigewordene Adreßleitung aus, um einen relativ aufwendigen, die m Dateninformationen eines Testwortes beim Einlesen zählendenden Zähler in der Anordnung einzusparen.

Weitere Einzelheiten der Erfindung ergeben sich aus den übrigen Unteransprüchen. Ein Ausführungsbeispiel sei nachfolgend anhand der Zeichnung näher erläutert. Dabei zeigt:

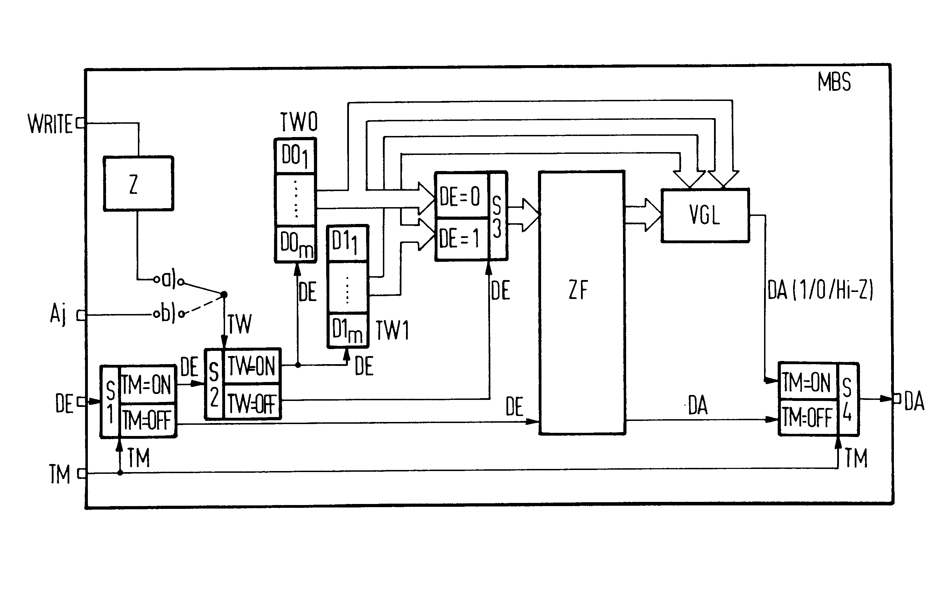

FIG 1     den prinzipiellen Aufbau eines Speicherbausteins der Mega-Bit-Generation gemäß der Erfindung.

Der in der Figur abgebildete Mega-Bit-Speicherbaustein MBS weist neben den bereits vorhandenen Schaltern S1 und S4 und dem Zellenfeld ZF zwei zusätzliche Testwortregister für die Testworte TW0 und TW1 vor dem Zellenfeld ZF, sowie eine Vergleichslogik VGL nach dem Zellenfeld ZF auf. Die Testwortregister können zum Beispiel aus Schieberegistern oder aus Auffangregistern aufgebaut sein.

Zwischen den Testwortregistern ist der Schalter S3 angeordnet, der beim Test im Multi-Bit-Modus über die Dateninformation DE den Inhalt eines der Testworte TW0 oder TW1 auswählt und in das Zellenfeld ZF weiterleitet.

Es gilt:

$$f(DE) = \begin{cases} f_1(DE) = TW1 = \{D1\}_{1,\ldots,m} \text{ für } DE = 1 \\ f_0(DE) = TW0 = \{D0\}_{1,\ldots,m} \text{ für } DE = 0 \end{cases},$$

wobei nun nicht mehr notwendigerweise $f_0 = \overline{f_1}$ gelten muß. $f_0$ und $f_1$ sind nun nicht mehr fest vorgegeben, sondern von außen mittels Programmierung frei wählbar.

Das Umschalten vom Beschreiben der Testwortregister auf das Ausgeben des Auswahlsignals DE zum Auswählen eines der Testworte TW0 oder TW1 erfolgt über den Schalter S2. Der Zeitpunkt des Umschaltens wird mit dem Signal TW, das entweder von einem Zähler Z mit einem Zählzyklus von 2 x m Zähleinheiten (Fall a) oder von einer Adreßleitung $A_j$ (Fall b) abgeleitet wird, gesteuert. Bei der Adreßleitung $A_j$ handelt es sich um eine im Multi-Bit-Testmodus nicht gebrauchte Adreßleitung. Für das Ausführungsbeispiel wird angenommen, daß ein Zähler im Speicherbaustein integriert ist.

Bei ausgeschaltetem Multi-Bit-Testmodus mit dem Signal TM = OFF, werden die am Dateneingang des Speicherbausteins ankommenden Dateninformationen DE über den Schalter S1 direkt zum Zellenfeld ZF weitergeleitet und in das Zellenfeld ZF an einer durch eine Adresse spezifizierten Stelle geschrieben. Beim Auslesen eines Inhaltes einer Zelle des Zellenfeldes ZF gelangt die Zelleninformation DA über den Schalter S4 unmittelbar an den Datenausgang des Speicherbausteines MBS.

Zum Testen des Speicherbausteins MBS schaltet das Signal TM = ON den Speicherbaustein MBS in den Multi-Bit-Testmodus. Weiter teilt das Einschalten des Testmodus dem Zähler Z des Speicherbausteins MBS mit, daß die ankommenden Dateninformationen der nachfolgenden 2 x m Schreibzyklen (durch Low-Impulse des Signals WRITE gekennzeichnet) in die Testwortregister zu schreiben sind. Dazu generiert der Zähler Z das Steuersignal TW = ON, das den Schalter S2 veranlaßt, das Einschreiben in die Testwortregister entsprechend einzuschalten. Die ersten m Dateninformationen DE am Dateneingang des Speicherbausteines MBS, die vom Zähler Z gezählt werden, gelangen über die Schalter S1 und S2 in das erste Testwortregister und bilden dort das Testwort TW0. Die zweiten m Datenenformationen am Dateneingang des Speicherbausteins MBS werden, vom Schalter S2 gesteuert, in das zweite Testwortregister geschrieben und bilden dort das Testwort TW1. Für die Testworte TW0 und TW1 muß nicht notwendigerweise die Beziehung

$$TW0 = \overline{TW1}$$

gelten. Gleichzeitig mit der Generierung zweier Testworte TW0 und TW1 werden der Vergleichslogik VGL die Testworte TW0 und TW1 zugeführt.

Nachdem 2 x m Dateninformationen DE eingelesen wurden, setzt der Zähler Z die Steuerleitung TW = OFF. Der Schalter S2 veranlaßt daraufhin, daß beim nächsten Schreibzyklus eines der Testworte TW0 oder TW1 auf eine m-dimensionale Zellengruppe des Zellenfeldes ZF abgebildet wird. Dabei kann das Testwort auf eine oder vorzugsweise nacheinander auf mehrere Zellengruppen abgebildet werden. Während des Abbildvorganges kann mittels des von außen an den Baustein angelegten Datums DE wahlfrei zwischen dem Testwort TW0 und TW1 umgeschaltet werden. Bei der Abbildung eines Testwortes TW0 oder TW1 auf die einzelnen Zellen einer m-dimensionalen Zellengruppe wird jeweils der Inhalt genau einer Bitstelle des Testwortes auf eine Zelle der Zellengruppe abgebildet. Auf diese Weise werden im Zellenfeld ZF an vorgegebener Stelle mit dem dazugehörigen Umfeld durch Wahl spezieller Testworte TW0 und TW1 die verschiedensten Bitmuster erzeugt.

Beim Auslesen werden die Zelleninhalte einer m-dimensionalen Zellengruppe des Zellenfeldes ZF der Umkehrabbildung unterworfen, indem sie die Vergleichslogik VGL mit den Testworten TW0 und TW1 vergleicht. Bei einem positiven Verlauf des Vergleichs wird das Ergebnis der Umkehrfunktion, d.h. je nachdem, ob sich das Bitmuster mit TW0 oder TW1 deckt, entsprechend 0 oder 1 am Datenausgang ausgegeben, während bei einem negativen Verlauf des Vergleichs der Datenausgang stattdessen in den Hi-Zustand oder Tristate-Zustand geschaltet wird.

Eine defekte Zelle könnte aber auch dadurch angezeigt werden, daß beim Auslesen von Zelleninhalten fehlerfreier Zellen der Ausgangspegel des Datenausganges des Speicherbausteines MBS 0 oder 1 ist, während der Pegel beim Auslesen einer Zellengruppe mit wenigstens einer, höchstens jedoch m-1 defekten Zellen entsprechend den umgekehrten Wert annimmt. Für die Funktion der Vergleichslogik VGL gilt:

$$f^{-1}\left(\left\{DA\right\}_{1,\ldots,m}\right) = \left\{\begin{array}{ll} 0 \text{ für} & DA_{1,\ldots,m} = TW0 \\ 1 \text{ für} & DA_{1,\ldots,m} = TW1 \\ \text{Tristate, Hi-Z} & \text{sonst.} \end{array}\right\}$$

Eine vereinfachte Ausführungsform der Schaltungsanordnung weist nur ein zusätzliches Testwortregister für ein Testwort TW0 auf, dessen Inhalt in Abhängigkeit von der Dateninformation DE nicht negiert (TW0) oder negiert ($\overline{TW0}$) bei fester Einzelzuordnung der Bitstellen des Testwortes zu den m Zellen einer Zellengruppe auf die Zellen der Zellengruppe abgebildet wird. Im übrigen arbeitet diese Schaltungsanordnung analog zur Schaltungsanordnung mit zwei zusätzlichen Testwortregistern.

## Patentansprüche

1. Verfahren zum Testen von Mega-Bit-Speicherbausteinen im Multi-Bit-Testmodus mit beliebigen Tetmustern, wobei beim Einlesen eines Ein-Bit-Datums das Ein-Bit-Datum gleichzeitig auf m Zellen einer Zellengruppe des Speicherzellenfeldes abgebildet wird, gemäß der m-dimensionalen Beziehung

$$f(DE) = \{DE\}_{1,\ldots,m} \text{ mit } DE \in \{0,1\}$$

und beim Auslesen der Zelleninhalte so einer Zellengruppe zur Erzeugung des ursprünglichen Ein-Bit-Datums die Zellengruppe umgekehrt abgebildet wird, gemäß der m-dimensionalen Umkehrfunktion

$$f^{-1}(\{DA\}_{1,\ldots,m}) = DA \text{ mit } DA \in \{0,1\}$$

**dadurch gekennzeichnet,** daß m einzeln in den Mega-Bit-Speicherbaustein (MBS) eingelesene Dateninformationen (DE) in einem Testwortregister zu einem m-dimensionalen Testwort (TW0) zusammengefaßt werden und anschließend bei fester Einzelzuordnung der Bitstellen des Testwortes (TW0) zu den Zellen einer m-dimensionalen, zum topologischen Umfeld eines bestimmten Bits gehörigen Zellengruppe das Testwort (TW0, bei DE = 0) oder das negierte Testwort ($\overline{TW0}$, bei DE = 1) auf eine genannte Zellengruppe bzw. nacheinander auf mehrere genannte Zellengruppen des Zellenfeldes (ZF) abgebildet wird.

2. Verfahren nach Anspruch 1, **dadurch gekennzeichnet,** daß wenigstens zwei wahlfrei, durch die eingelesene Dateninformation (DE) auswählbar, auf die Zellengruppen des Zellenfeldes (ZF) abbildbare, voneinander unabhängige Testworte (TW0 und TW1) generiert werden.

3. Verfahren nach Anspruch 1 oder 2, **dadurch gekennzeichnet,** daß die Testworte (TW0 und/oder TW1) einer Vergleichslogik (VGL) zugeführt werden, die die tatsächlichen Zelleninhalte einer Zellengruppe mit den ursprünglich eingeschriebenen Testworten (TW0 oder TW1) vergleicht und abhängig vom Vergleich ein Gut- bzw. Schlechtsignal erzeugt.

4. Anordnung zur Durchführung des Verfahrens nach einem der Ansprüche 1 oder 3, **dadurch gekennzeichnet,** daß der Mega-Bit-Speicherbaustein (MBS) ein Testwortregister zur Aufnahme eines m-dimensionalen Testwortes (TW0) vor dem Zellenfeld (ZF) und eine mit dem Testwortregister verbundene Vergleichslogik (VGL) nach dem Zellenfeld (ZF), sowie mehrere Schalter (S2 und S3) zur Steuerung des Einlesens eines Testwortes in das Testwortregister bzw. Einschreibens des Testwortes oder des negierten Testwortes (TW0 oder $\overline{TW0}$) in das Zellenfeld (ZF) aufweist.

5. Anordnung zur Durchführung des Verfahrens nach einem der Ansprüche 2 oder 3, **dadurch gekennzeichnet,** daß der Mega-Bit-Speicherbaustein (MBS) zwei Testwortregister zur Aufnahme zweier m-dimensionalen Testwortes (TW0 und TW1) vor dem Zellenfeld (ZF) und eine mit den Testwortregistern verbundene Vergleichslogik (VGL) nach dem Zellenfeld (ZF), sowie mehrere Schalter (S2 und S3) zur Steuerung des Einlesens der Testworte in die Testwortregister bzw. Einschreibens der Testworte (TW0 oder TW1) in das Zellenfeld (ZF) aufweist.

6. Anordnung nach Anspruch 4 bzw. 5, **dadurch gekennzeichnet,** daß ein Zähler (Z) mit Zählzyklus m bzw. 2xm vorgesehen ist, der das Ende des Einlesens des Testwortes (TW0) bzw. der Testworte (TW0 und TW1) festlegt und das Schreiben eines Testwortes (TW0 oder $\overline{TW0}$ bzw. TW0 oder TW1) in das Zellenfeld (ZF) anregt.

7. Anordnung nach Anspruch 4 bzw. 5, **dadurch gekennzeichnet,** daß ein Steuereingang vorgesehen ist, über den eine durch den Multi-Bit-Testmodus geringeren benötigten Adreßraumes freigewordene Adreßleitung $A_j$ das Ende des Einlesens des Testwortes (TW0) bzw. der Testworte (TW0 und TW1) festlegt, und das Schreiben eines Testwortes (TW0 oder $\overline{TW0}$ bzw. TW0 oder TW1) in das Zellenfeld (ZF) anregt.

## Claims

1. A method for testing mega-bit memory chips with arbitrary test patterns in the multi-bit test mode, in which during the reading-in of a one-bit data item the one-bit data item is simultaneously mapped onto m cells of a cell group of the memory cell array, in accordance with the m-dimensional relation

$$f(DE) = (DE)_{1, \dots, m} \text{ with } DE \in \{0,1\}$$

and during the reading-out of the cell contents of such a cell group, the cell group, for generating the original one-bit data item, is inversely mapped in accordance with the m-dimensional inverse function

$$f^{-1}(\{DA\}_{1, \dots, m}) = DA \text{ with } DA \in \{0,1\}$$

characterised in that m data information items (DE) read individually into the mega-bit memory chip (MBS) are combined to form an m-dimensional test word (TW0) in a test word register and subsequently the test word (TW0, with DE = 0) or the negated test word ($\overline{TW0}$, with DE = 1), with fixed individual allocation of the bit positions of the test word (TW0) to the cells of an m-dimensional cell group belonging to the topological environment of a particular bit, is mapped onto a said cell group or successively onto several said cell groups of the cell array (ZF).

2. Method according to Claim 1, characterised in that at least two mutually independent test words (TW0 and TW1), which can be mapped to the cell groups of the cell array (ZF) and which are optionally selectable by the data information item (DE) read in, are generated.

3. Method according to Claim 1 or 2, characterised in that the test words (TW0 and/or TW1) are supplied to a comparison logic (VGL) which compares the actual cell contents of a cell group with the test words (TW0 or TW1) originally written in and generates an acceptance or rejection signal in dependence on the comparison.

4. Arrangement for carrying out the method according to one of Claims 1 or 3, characterised in that the mega-bit memory chip (MBS) has a test word register for receiving an m-dimensional test word (TW0) preceding the cell array (ZF) and a comparison logic (VGL), connected to the test word register, following the cell array (ZF), and several switches (S2 and S3) for controlling the reading of a test word into the test word register or the writing of the test word or of the negated test word (TW0 or $\overline{TW0}$) into the cell array (ZF).

5. Arrangement for carrying out the method according to one of Claims 2 or 3, characterised in that the mega-bit memory chip (MBS) exhibits two test word registers for receiving two m-dimensional test words (TW0 and TW1) preceding the cell array (ZF) and a comparison logic (VGL), connected to the test word registers, following the cell array (ZF), and several switches (S2 and S3) for controlling the reading of the test words into the test word registers and, respectively, writing of the test words (TW0 or TW1) into the cell array (ZF).

6. Arrangement according to Claim 4 or 5, characterised in that a counter (Z) with a counting cycle of m or, respectively 2xm is provided which defines the end of the reading-in of the test word (TW0) or of the test words (TW0 and TW1) and stimulates the writing of a test word (TW0 or $\overline{TW0}$ or, respectively, TW0 or TW1) into the cell array (ZF).

7. Arrangement according to Claim 4 or 5, characterised in that a control input is provided via which an address line $A_j$, which has become free due to the lesser address space needed by the multi-bit test mode, defines the end of the reading-in of the test word (TW0) or of the test words (TW0 and TW1) and stimulates the writing of a test word (TW0 or $\overline{TW0}$ or, respectively, TW0 or TW1) into the cell array (ZF).

**Revendications**

1. Procédé pour tester des modules de mémoire à mégabits dans un mode de test multibits à configurations de test arbitraires du type dans lequel, lors de la mémorisation d'une donnée à un bit, la donnée à un bit est reproduite simultanément sur m cellules d'un groupe de la plage de cellules de mémoire suivant la relation de dimension m :

$$f(DE) = \{DE\}_{1,\dots,m} \text{ avec DE } \epsilon \{0,1\}$$

et, lors de la lecture des contenus des cellules d'un tel groupe de cellules, le groupe de cellules est reproduit avec inversion pour créer la donnée initiale à un bit selon la fonction inverse de dimension m :

$$f^{-1}(\{DA\}_{1,\dots,m}) = DA \text{ avec DA } \epsilon \{0,1\}$$

caractérisé en ce que m informations de données individuelles (DE) mémorisées dans le module de mémoire à mégabits (MBS) sont réunies dans un registre de mot de test en un mot de test (TW0) de dimension m et, qu'ensuite, l'attribution pour une coordination individuelle et fixe de la position binaire du mot de test (TW0) avec les cellules d'un groupe de cellules de dimension m, et appartenant à un environnement topologique d'un bit précis, le mot de test (TW0, pour DE = 0) ou le mot de test inverse ($\overline{TW0}$, pour DE = 1) est reproduit sur un groupe désigné de cellules ou successivement sur plusieurs groupes désignés de cellules du champ de cellules (ZF).

2. Procédé suivant la revendication 1, caractérisé en ce que, sont générés au moins deux mots de test (TW0 et TW1) optionnels, indépendants l'un de l'autre, pouvant être sélectionnés par l'information de données (DE) mémorisée et pouvant être reproduits sur le groupe des cellules du champ de cellules (ZF).

3. Procédé suivant la revendication 1 ou 2, caractérisé en ce que les mots de test (TW0 et/ou TW1) sont envoyés à un élément logique de comparaison (VGL), qui compare le contenu réel des cellules d'un groupe de cellules aux mots de test (TW0 ou TW1) originaux mémorisés et qui, en fonction de la comparaison, génère un bon ou un mauvais signal.

4. Agencement pour la mise en oeuvre du procédé selon l'une des revendications 1 ou 3, caractérisé en ce que le module de mémoire à mégabits (MBS) comporte un registre de mots de test, en amont du champ de cellules (ZF), pour la réception d'un mot de test (TW0) de dimension m et un élément logique de comparaison (VGL) qui est relié au registre de mot de test, en aval du champ de cellules (ZF), ainsi que plusieurs commutateurs (S2 et S3) pour commander la mémorisation d'un mot de test dans le registre de mot de test et pour écrire, dans le champ de cellules (ZF), le mot de test ou le mot de test inverse (TW0 ou $\overline{\text{TW0}}$).

5. Agencement pour la mise en oeuvre du procédé selon l'une des revendications 2 ou 3, caractérisé en ce que le module de mémoire à mégabits (MBS) comporte deux registres de mots de test, monté en amont du champ de cellules (ZF), pour la réception des deux mots de test (TW0 et TW1) de dimension m et un élément logique de comparaison (VGL), monté en aval du champ de cellules (ZF), et relié au registre de mots de test, ainsi que plusieurs commutateurs (S2 et S3) pour commander la mémorisation du mot de test dans le registre de mots de test et pour écrire le mot de test (TW0 ou TW1) dans le champ de cellules (ZF).

6. Agencement suivant la revendication 4 ou 5, caractérisé en ce qu'il est prévu un compteur (Z) à cycle de comptage m ou 2xm, qui détermine la fin de la mémorisation du mot de test (TW0) ou des mots de test (TW0 et TW1) et qui excite l'écriture d'un mot de test (TW0 ou $\overline{\text{TW0}}$ respectivement TW0 ou TW1) dans le champ de cellules (ZF).

7. Dispositif selon la revendication 4 ou 5, caractérisé en ce qu'il est prévu une entrée de commande, par laquelle une ligne d'adresse $A_j$, rendue disponible par l'intermédiaire du mode de test multibits nécessitant un plus faible espace d'adresses, détermine la fin de la mémorisation du mot de test (TW0) ou des mots de test (TW0 et TW1) et excite l'écriture d'un mot de test (TW0 ou $\overline{\text{TW0}}$ respectivement TW0 ou TW1) dans le champ de cellules (ZF).

7